# EUROPÄISCHE PATENTSCHRIFT

(11) **EP 3 304 734 B1**
(45) Veröffentlichungstag und Bekanntmachung des Hinweises auf die Patenterteilung: **17.03.2021**
(21) Anmeldenummer: 16727335.8
(22) Anmeldetag: 23.05.2016
(51) Int. Cl.: H03G 3/30

(54) **VORRICHTUNG UND VERFAHREN ZUR LAUTSTÄRKENREGULIERUNG**
APPARATUS AND METHOD FOR VOLUME CONTROL
DISPOSITIF ET PROCÉDÉ DE RÉGLAGE DE L'INTENSITÉ SONORE

(30) Priorität: 29.05.2015 EP 15169998
(43) Veröffentlichungstag der Anmeldung: 11.04.2018
(73) Patentinhaber: Fraunhofer-Gesellschaft zur Förderung der angewandten Forschung e.V., 80686 München (DE)
(72) Erfinder: SCHARRER, Sebastian, 90518 Altdorf (DE); UHLE, Christian, 92289 Ursensollen (DE); HELLMUTH, Oliver, 91054 Buckenhof (DE); LUVIZOTTO, André, 90403 Nürnberg (DE)
(74) Vertreter: Pfitzner, Hannes
(86) Internationale Anmeldenummer: PCT/EP2016/061542
(87) Internationale Veröffentlichungsnummer: WO 2016/193033

(56) Entgegenhaltungen:
- US-A1- 2008 253 586
- US-A1- 2010 046 765
- US-A1- 2014 140 537

## Beschreibung

Ausführungsbeispiele der vorliegenden Erfindung beziehen sich auf eine Vorrichtung und ein Verfahren zur Lautstärkenregulierung für zumindest zwei Audioquellen sowie auf einen Radiotuner mit entsprechender Lautstärkenregulierung, die auch als zweistufige Lautheits-Normalisierung bezeichnet werden kann. Ein weiteres Ausführungsbeispiel bezieht sich auf ein entsprechendes Computerprogramm zur Durchführung des Verfahrens zur Lautstärkenregulierung bzw. Lautheits-Normalisierung.

Die wahrgenommene Lautstärke bzw. Lautheit unterschiedlicher Radiosender schwankt von Sender zu Sender. Sogenannte Main-Stream Sender wie Bayern 3 oder Antenne Bayern sind im Vergleich zu Klassik Sendern wie Bayern Klassik wahrgenommen wesentlich lauter.

Diese Unterschiede werden heutzutage durch manuelles Nachregeln über den Lautstärkeknopf angeglichen. Für den Benutzer kann es auf Dauer störend wirken. Falls Radio in einem Fahrzeug gehört, wird hat es sogar Sicherheitsrelevanz da der Fahrer während dem manuellen Nachregeln zwangsläufig vom Verkehrsgeschehen abgelenkt ist.

Es gibt bereits einige Ansätze die Lautstärke bzw. Lautheit abhängig vom Signal (adaptiv) anzupassen. Beispielsweise beschreibt die ITU Norm BS.1770 ein Verfahren, wie die gehörrichtige Berechnung der Lautheit erfolgen soll. Nachteile dieser Methoden sind, dass das Audiosignal während des Hörens angepasst wird. Es entstehen Artefakte wie "Pumpen" (Hörbare, schnelle Lautstärke-Anpassungen), starke Nachregelungen bei Plosivlauten oder Verringerung der Dynamik.

Diese Verfahren können den Ansprüchen an transparente, unverfälschte Audiowiedergabe auf Grund ihrer Natur nicht erfüllen. In Anwendungen mit HiFi Ansprüchen wie hochwertigen Audiosystemen Fahrzeugen kommen diese Algorithmen daher nicht zum Einsatz. Die US 2010/0046765 A1 beschreibt einen Ansatz zur Lautstärkeregulierung, wobei hier die Regulierung auf einem Durchschnittswert je Eingang sowie auf einer kurzzeitigen Nachregelung basiert. Die US 2014/0140537 A1 bezieht sich auf eine Loudness-Steuerung für eine Mehrzahl von Eingängen, die kontinuierlich die Loudness nachregelt. Es besteht der Bedarf nach einem verbesserten Ansatz.

Aufgabe der vorliegenden Erfindung ist es, ein Konzept zur automatischen Lautstärkenregulierung zu schaffen, das die Audiowiedergabe im Wesentlichen unverfälscht belässt.

Die Aufgabe wird durch die unabhängigen Patentansprüche gelöst.

Die Erfindung ist in den unabhängigen Ansprüchen definiert.

Ausführungsbeispiele der vorliegenden Erfindung schaffen eine Vorrichtung zur Lautstärkenregulierung für zumindest zwei Audioquellen, wie z. B. zwei Radiosender. Die Vorrichtung umfasst einen Lautheitsanalysator sowie einen Lautstärkenregler. Der Lautheitsanalysator ist ausgebildet, um ein Audiosignal der ersten der zwei Audioquellen, d. h. also beispielsweise für einen ersten Sender, über eine Zeitdauer (von beispielsweise 1 bis 5 Minuten) zu analysieren, abhängig hiervon einen ersten Lautheitswert zu ermitteln und diesen mit Zuordnung zu der ersten der zwei Audioquellen zu speichern. Weiter ist der Lautheitsanalysator ausgebildet, um ein Audiosignal der zweiten der zwei Audioquellen, d. h. beispielsweise für einen zweiten Sender, über eine Zeitdauer (die beispielsweise dieselbe sein kann) zu analysieren und abhängig hiervon einen zweiten Lautheitswert zu ermitteln und diesen mit Zuordnung zu der zweiten der zwei Audioquellen zu speichern. Der Lautstärkenregler ist ausgebildet, um das Audiosignal der aktuell gewählten ersten und/oder zweiten der zwei Audioquellen entsprechend dem zugeordneten ersten und/oder zweiten Lautheitswert anzupassen.

Die der Erfindung zugrundeliegende Erkenntnis liegt darin, zuerst die unterschiedlichen Audioquellen bzw. Radiosendern bezüglich ihrer Lautheit zu analysieren und ausgehend von der Analyse eine entsprechend Lautheitsinformation (Lautheitswert) zu speichern, um dann in Abhängigkeit vom Analyseergebnis je zugehörige Audioquelle die Lautstärkenregelung je Audioquelle bzw. je Sender zu wählen. Das Analysieren erfolgt bevorzugt (aber nicht notwendiger Weise) über eine längere Zeitdauer, von beispielsweise 5 Minuten, um hier einen gut repräsentativen Mittelwert für die Audioquelle zu erhalten. Die Lautstärkenregelung im zweiten Schritt erfolgt vorzugsweise so, dass bei der Wiedergabe das resultierende Audiosignal für die erste und die zweite Quelle in etwa gleiche Lautstärke bzw. Lautheit hat. Insofern kann in diesem Zusammenhang auch von Normalisierung gesprochen werden. Dieser Ansatz hat den Vorteil, dass durch die Analyse, die im Regelfall einige Sekunden, wenn nicht sogar Minuten in Anspruch nimmt, ein guter Mittelwert erhalten wird und es zu den oben genannten nachteiligen Effekten wie "Pumpen" bzw. "Einschwingen" nicht kommt. Weiter bleibt so auch der Dynamikumfang des Audiosignals erhalten. Dadurch, dass jeder Audioquelle ein Lautheitswert in zugeordneter Weise gespeichert ist, kann bei Wahl der Audioquelle bzw. beim Umschalten die korrekte Lautstärkenwahl gleichsam mit erfolgen (keine Verzögerung).

Der eben erläuterte Vorgang kann als Hauptstufe bei der Lautheits-Normalisierung bezeichnet werden. Um bei erster Anwahl eines Sender, zu dem kein Lautheitswert vorliegt, ebenso einen akzeptable Normalisierung zu erreichen, kann entsprechend Ausführungsbeispielen in einer Vorstufe eine kurzfristige Normalisierung basierend auf einem aktuell ermittelten Lautheitswert erfolgen. Deshalb umfasst das Verfahren den Schritt des Ermitteln eines vorläufigen Lautheitswerts und des Regulierens der Lautstärke der aktuell gewählten Quelle (Sender) basierend auf dem vorläufigen Lautheitswert bzw. dem aktuell ermittelten, vorläufigen Lautheitswert. Diese Lautstärken-Normalisierung in der Vorstufe wird solange durchgeführt, bis ein Lautheitswert über einen repräsentieren Zeitraum (Lernphase je Quelle) ermittelt und gespeichert ist. Da entsprechend diesem Ausführungsbeispiel die Lautstärken-Normalisierung in Vor- und Hauptstufe untergliedert ist, kann auch von einer automatischen, zweistufigen Lautstärkenregelung (bzw. einer zweistufigen Lautheits-Normalisierung gesprochen werden.

Der einmal ermittelte und gespeicherte Lautheitswert je Audioquelle wird während des Betriebs der Audioquelle im Ausnahmefall aktualisiert. Hierzu wird bei Wahl der Audioquelle die Lautheit analysiert und, für den Fall, dass eine signifikante Abweichung vorliegt, der Lautheitswert aktualisiert und neu gespeichert. Das Aktualisieren erfolgt entsprechend Ausführungsbeispielen so, dass die Aktualisierung einen geringen Einfluss auf den Lautheitswert und damit auf die Lautstärkenanpassung hat, Hieraus resultiert, dass es zu keiner hörbaren Anpassung der Lautstärke nach der Lernphase kommt, wobei dennoch sichergestellt ist, dass bei Veränderungen der Audioquelle, diese entsprechend Berücksichtigung finden. Hierbei erfolgt eine Art Gewichtung, wobei die Gewichtung dann so gewählt ist, dass die Anpassung des Lautheitswerts in der Anpassungsphase eine geringere Gewichtung genießt als die Anpassung des Lautheitswerts in der Lernphase. Die Anpassung des Lautheitswerts erfolgt nur dann, wenn eine signifikante Abweichung des neu ermittelten Lautheitswerts von dem gespeicherten Lautheitswert vorliegt. Diese signifikante Abweichung kann prozentual mit 10 % angegeben werden.

Entsprechend weiteren Ausführungsbeispielen kann das Aktualisieren der Lautheitswerte und/oder entsprechend wiederum weiteren Ausführungsbeispielen das Ermitteln eines neuen Lautheitswerts für eine neue Quelle (Sender) im Hintergrund erfolgen, wenn hier für den Analysator die technischen Voraussetzungen geschaffen sind. Im Beispiel eines Radiotuners hieße das nämlich, dass ein zweites Tunerteil vorgesehen ist, um den zweiten Sender im Hintergrund zu empfangen und zu analysieren. Diese beiden Ausführungsbeispiele haben den Vorteil, dass sofort ab dem Umschalten ein ermittelter bzw. aktualisierter Lautheitswert vorliegt, so dass die Lautheit effektiv normalisiert werden kann.

Weitere Ausführungsbeispiele beziehen sich auf einen Radiotuner, der oben erläuterte Vorrichtung zur Lautstärkenregulierung umfasst. Entsprechend weiteren Ausführungsbeispielen kann dieser Radiotuner auch zwei Tunereinheiten haben.

Ein weiteres Ausführungsbeispiel bezieht sich auf ein entsprechendes Verfahren zur Lautstärkenregulierung. Entsprechend weiteren Ausführungsbeispielen kann dieses Verfahren auch durch ein Computerprogramm ausgeführt werden.

Weiterbildungen sind in den Unteransprüchen definiert. Nachfolgend werden Ausführungsbeispiele anhand der beiliegenden Zeichnungen erläutert. Es zeigen:
- Fig. 1a: eine Vorrichtung zur Lautstärkenregulierung gemäß einem Ausführungsbeispiel;
- Fig. 1b: ein entsprechendes Verfahren zur Lautstärkenregulierung entsprechend einem weiteren Ausführungsbeispiel; und
- Fig. 2: einen Radiotuner mit einer entsprechenden Vorrichtung zur Lautstärkenregulierung gemäß Ausführungsbeispielen.

Bevor nachfolgend Ausführungsbeispiele der vorliegenden Erfindung anhand der Figuren im Detail erläutert werden, sei darauf hingewiesen, dass gleiche oder gleichwirkende Elemente und Strukturen mit gleichen Bezugszeichen versehen sind, so dass die Beschreibung derer aufeinander anwendbar bzw. austauschbar ist.

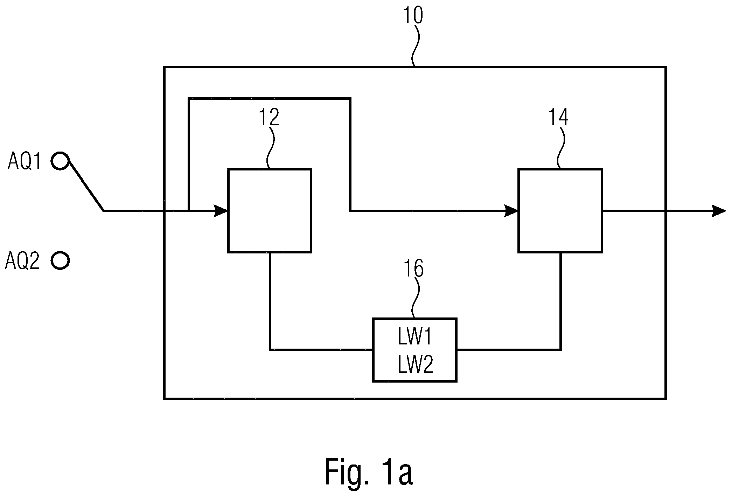

Fig. 1a zeigt eine Vorrichtung 10 zur Lautstärkenregulierung für zumindest zwei Audioquellen AQ1 und AQ2. Die Vorrichtung 10 umfasst einen Lautheitsanalysator 12 und einen Lautstärkenregler 14. Zusätzlich weist die Vorrichtung 10 auch noch einen Speicher 16 auf. Der Lautheitsanalysator 12 ist eingangsseitig, d. h. in schaltbarer Weise verbindbar mit den Audioquellen AQ1 und AQ2 angeordnet. Das Signal von AQ1 und AQ2 wird entweder von dem Audioanalysator 12 an den Lautstärkenregler 14 weitergeleitet oder gebypasst.

Die unterschiedlichen Audioquellen AQ1 und AQ2 könnten beispielsweise zwei unterschiedliche Radiosender, aber auch andere Eingangsquellen, wie z. B. CD und Radio darstellen, die entweder mittels des Radiotuners oder mittels eines Vorverstärkers umgeschaltet werden. Das Audiosignal (digital oder analog) der Audioquellen AQ1 oder AQ2 wird von dem Lautheitsanalysator 12 empfangen, der dieses über eine Zeitdauer von beispielsweise 60 Sekunden oder 300 Sekunden oder sogar mehr analysiert und abhängig davon einen Lautheitswert zugehörig zu der jeweiligen Audioquelle AQ1 oder AQ2 ermittelt. Durch die lange Zeitkonstante (beispielsweise 1 bis 5 Minuten) kann der Mittelwert der Lautheit (LW1 oder LW2) für diesen Sender bzw. die Audioquelle berechnet werden, welcher der tatsächlichen Lautheit entspricht.

Der ermittelte Lautheitswert (LW1 für die Quelle AQ1 bzw. LW2 für die Quelle AQ2) wird in dem Speicher 16 abgelegt. Im Regelfall ist der Speicher 16 ein nicht flüchtiger Speicher, so dass die Lautheitswerte LW1 oder LW2 auch nach dem Aus- und Einschalten erhalten bleiben. An dieser Stelle sei auch angemerkt, dass der Speicher 16 meist bereits in den Radiotunern vorhanden ist, um beispielsweise die Senderkurzwahltasten oder die zuletzt gehörte Lautstärke zu speichern. Der Lautstärkenregler 14 passt nun direkt das Audiosignal der gewählten Quelle AQ1 oder AQ2 ausgehend von dem abgelegten Lautheitswert LW1 oder LW2 an.

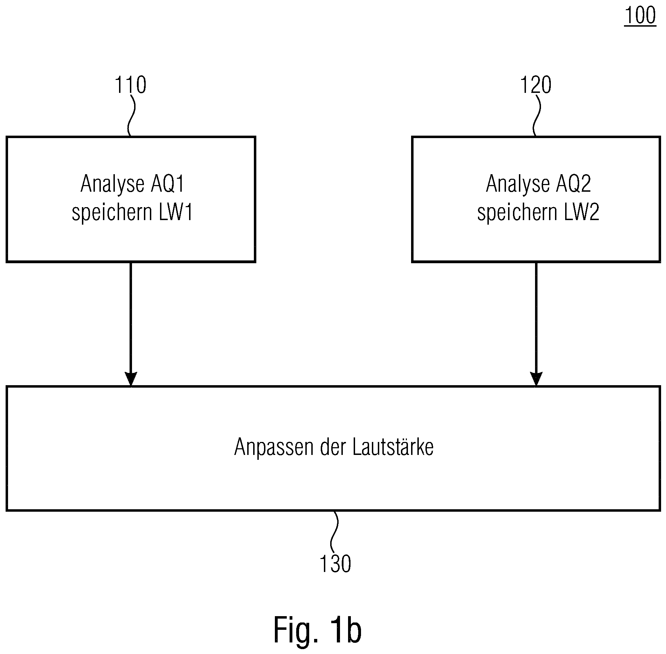

Diese Verhaltensweise der Vorrichtung 10 kann auch anhand des Verfahrens 100, welches in Fig. 1b dargestellt ist, erläutert werden. Das Verfahren 100 umfasst entweder die parallel oder nacheinander (d. h. zu unterschiedlichen Zeitpunkten, je nachdem welche Audioquelle (AQ1 oder AQ2) gerade gewählt ist) ausgeführten Schritte 110 und 120. Der Schritt 110 bezieht sich auf das Analysieren der Audioquelle AQ1 und das Speichern des Lautheitswerts LW1, während sich der Schritt 120 auf das Analysieren der Audioquelle AQ2 und das Speichern des Lautheitswerts LW2 bezieht. Ausgehend von den gespeicherten Werten LW1 und LW2 wird eben in einem dritten Schritt 130 die Lautstärke der jeweils gewählten Quelle angepasst.

Wie bereits oben erläutert, ist die in dem ersten Schritt erfolgte Lautheitsmessung und die Anpassung mit einer langsamen Regelungszeit verbunden, so dass die Änderung der Lautstärke in dem Schritt 130 kaum hörbar stattfindet. So können die oben erläuterten Nachteile vermieden werden.

Der Schritt 130 kann bei einer späteren Wiederanwahl der jeweiligen Quelle AQ1 und AQ2 wiederholt werden, um das Lautstärkeniveau zu nivellieren. Diese Nutzung der in einer sogenannten Lernphase ermittelten Lautstärkewerte LW1 und LW2 zur Nivellierung der Lautstärke bei der Wiederanwahl eines Senders basiert auf der Annahme, dass eine bestimmte Radiostation über sehr lange Perioden (mehrere Monate bis hin zu mehreren Jahren) eine einheitliche Grundlautstärke bzw. durchschnittliche Lautstärke beibehält. Durch das Speichern der Lautstärkewerte LW1 und LW2 und den Schritt 130 wird der Vorteil geschaffen, dass von einem beliebigen Sender auf einen Sender mit einer vorabgespeicherten Lautheitswert gewechselt werden kann, wobei sofort die Normalisierung der Lautstärke am Ausgang erfolgt. Hierbei ist infolgedessen keine Anpassung notwendig, so dass ein transparenter, dynamikerhaltenden Musikgenuss gewährleistet wird.

Um während der Lernphase - d.h. beispielsweise bei erster Anwahl eines Senders wenn noch kein Lautheitswert ermittelt werden konnte - auch eine Normalisierung der Lautstärke zu ermöglichen, kann in einer sogenannten Vorstufe (in Abgrenzung zu der oben erläuterten Hauptstufe bei der Lautstärken-Normalisierung) auch eine kurzfristige Regelung erfolgen. Hierzu wird dann in der Vorstufe ein vorläufiger Lautheitswert im laufenden Betrieb, d.h. ab der ersten Sekunde der Senderanwahl, ermittelt und basierend auf diesem (aktuellen) Lautheitswert das Regulieren der Lautstärke durchgeführt. Auch wenn diese kurzfristige Regelung in der Vorstufe zu Verfälschungen, insbesondere bzgl. des Dynamikbereichs, der aktuellen Quelle führen kann, kann hierdurch für jeden Zeitpunkt und jede Quelle eine Normalisierung sichergestellt werden.

Die Lautstärken-Normalisierung der Vorstufe wird solange durchgeführt, bis die Lernphase der aktuellen Quelle abgeschlossen ist, z.B. 60 Sekunden bis 300 Sekunden , so dass in die Hauptstufe gewechselt werden kann, wobei zumindest der Schritt 110 oder 120 parallel zu der Vorstufe ausgeführt wird.

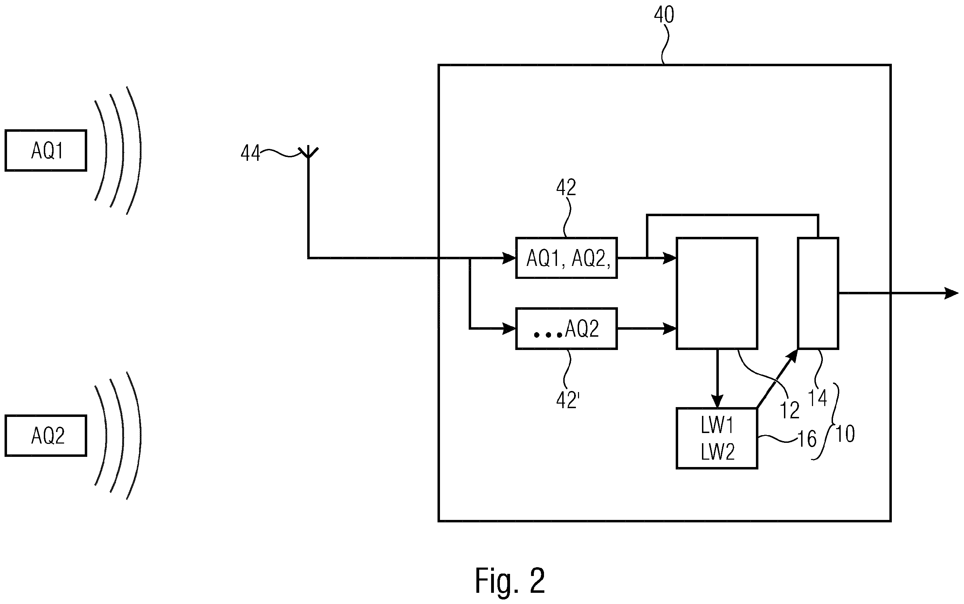

An dieser Stelle sei angemerkt, dass das Verfahren 100 bzw. insbesondere die Schritte 110 und 120 deshalb parallel dargestellt sind, weil, wie in Bezug auf Fig. 2 beschrieben werden wird, entsprechend weiteren Ausführungsbeispielen das Ermitteln der Lautheitswerte LW1 und LW2 durch Analysieren der Audioquellen AQ1 und AQ2 gleichzeitig (d.h. für eine Audioquelle im Hintergrund) erfolgen kann.

Das Durchführen der Schritte 110 und 120 erfolgt nicht nur initial, d. h. in einer sogenannten Lernphase, sondern auch während des ständigen Betriebs. Um auf eventuelle Änderungen der Lautstärke eines Radiosenders im Laufe der Zeit reagieren zu können, läuft im Hintergrund eine Messung passiv mit. Weicht der gemessene Wert vom gespeicherten Wert über längere Zeit ab, kann dezent nachgeregelt werden. Diese Nachregelung stellt aber keinen nennenswerten Eingriff in die Dynamik der Musik dar.

Bezugnehmend auf Fig. 1a sei angemerkt, dass es alternativ auch möglich wäre, dass die eigentliche Anpassung des Audiosignals AQ1 bzw. AQ2 gar nicht in der Vorrichtung 10 erfolgt, sondern dass die Vorrichtung 10 mittels des Lautstärkenreglers 14 nur ein Lautstärkenregelsignal zur Anpassung der Lautstärke des aktuell gewählten Audiosignals ausgibt.

Fig. 2 zeigt ein weiteres Ausführungsbeispiel, nämlich einen Radiotuner 40, der einen ersten Tunerteil 42 aufweist. Der erste Tuner 42 ist mit der Antenne 44 verbunden und kann so die mehreren Radiosender bzw. Radioquellen AQ1 und AQ2 empfangen bzw. anwählen, indem auf die entsprechende Trägerfrequenz mittels des Tuners 42 gewechselt wird. Dem Radiotuner 42 nachgeschaltet ist die Bezug nehmend auf Fig. 1a erläuterte Vorrichtung 10 zur Lautstärkenregulierung.

Entsprechend weiteren Ausführungsbeispielen kann der Radiotuner 40 einen zweiten parallelen Tunerteil 42' umfassen, der ebenfalls mit der Antenne 44 verbunden ist und unter anderem dazu genutzt wird, dass der Lautheitsanalysator 12 parallel zum aktuellen Empfangen einer ersten Radioquelle (z. B. der Radioquelle AQ1) eine zweite Radioquelle (z. B. AQ2) empfängt und diese hinsichtlich ihrer Lautheit analysiert. So kann vorteilhafterweise die Lernphase, die typischerweise 1 bis 5 Minuten braucht, im Hintergrund erfolgen. Derartige parallele Tunerteile (Radioempfänger) ist beispielsweise bei heutigen Premiumfahrzeugen der Regelfall. Derzeit liegt die Aufgabe dieses zweiten Radiotuners darin, im Hintergrund nach verfügbaren Radiostationen zu suchen, ohne dass die Audiowiedergabe des aktuellen Senders unterbrochen wird. Die gefundenen Radiostationen werden meist mit Sendernamen (RDS) im HMI (Display im Fahrzeug) als Liste der verfügbaren Sender angezeigt. Dieser parallele Tuner 42' kann demnach dazu verwendet werden, die Lautheit der gefundenen Radiostationen zu ermitteln. Wird nun auf einen dieser Sender gewechselt, steht der berechnete Lautheitswert LW bereits bereit, so dass die Lautstärkenregulierung, wie oben beschrieben, arbeiten kann, ohne dass hörbare Anpassungen vorgenommen werden müssen.

Dieser zweite Tuner 42 dient nicht nur zur Verkürzung bzw. Vermeidung der Lernzeit, da diese im Hintergrund verläuft, sondern kann auch dazu genutzt werden, die Sender, für welche ein Lautheitswert bereits gespeichert ist, auszuwerten, um den gespeicherten Lautheitswert zu aktualisieren.

Auch wenn bei obigen Ausführungsbeispielen immer davon ausgegangen wurde, dass die Audioquelle ein Radiosender ist, ist das hier vorgeschlagene Konzept auf beliebige andere Quellen verwendbar, welche beispielsweise eine im Mittel gleichbleibende Lautheit aufweisen.

An dieser Stelle sei auch noch einmal angemerkt, dass die oben erwähnte lange Zeitkonstante, beispielsweise 1 bis Minuten oder 1 bis mehrere Stunden oder mehrere Tage auch kürzer ausfallen kann, wobei dann mit dem Nachteil zu rechnen ist, dass bei erstmaliger Nutzung eine hörbare Anpassung stattfindet. Hierdurch wird bei erneutem Aufrufen des Senders die Lautstärke entsprechend vorab angepasst.

Auch wenn obige Ausführungsbeispiele immer im Zusammenhang mit einer Vorrichtung beschrieben wurden, schaffen weitere Ausführungsbeispiele ein Verfahren zur Anpassung der Lautstärke bzw. Lautheit eines durch einen Sender bereitgestellten Audiosignals, mit Durchführen einer Lautheitsmessung und Anpassung gemäß bekannten Vorgehensweisen aber mit reduzierter Regelungszeit durchgeführt wird, um einen Wert der tatsächlichen Lautheit für den Sender zu bestimmen, bei einem Wechsel von einem beliebigen anderen Sender auf den Sender, Verwenden des ermittelten Lautheitswerts zur Ausgabe des Audiosignals mit der normalisierten Lautstärke.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Es kann ein Datenträger vorgesehen sein, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein kann ein Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel somit ein Computerprogramm, das einen Programmcode zum Durchführen eines der hierin beschriebenen Verfahren aufweist, wenn das Computerprogramm auf einem Computer abläuft.

Weiter kann ein Datenträger (oder ein digitales Speichermedium oder ein computerlesbares Medium) vorgesehen sein, auf dem das Computerprogramm zum Durchführen eines der hierin beschriebenen Verfahren aufgezeichnet ist.

Weiter kann ein Datenstrom oder eine Sequenz von Signalen vorgesehen sein, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Weiter kann eine Verarbeitungsvorrichtung vorgesehen sein, beispielsweise ein Computer oder ein programmierbares Logikbauelement, die dahin gehend konfiguriert oder angepasst ist, eines der hierin beschriebenen Verfahren durchzuführen.

Weiter kann ein Computer vorgesehen sein, auf dem das Computerprogramm zum Durchführen eines der hierin beschriebenen Verfahren installiert ist.

Weiter kann eine Vorrichtung oder ein System vorgesehen sein, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Weiter kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Es kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Vorrichtung (10) zur Lautstärkenregulierung für zumindest zwei Audioquellen (AQ1, AQ2), wobei die Vorrichtung enthält:
einen Lautheitsanalysator (12), der ausgebildet ist, um ein Audiosignal der ersten der zwei Audioquellen (AQ1) über eine Zeitdauer zu analysieren und abhängig hiervon einen ersten Lautheitswert (LW1) zu ermitteln und diesen mit Zuordnung zu der ersten der zwei Audioquellen (AQ1) zu speichern, und um ein Audiosignal der zweiten der zwei Audioquellen (AQ2) über eine Zeitdauer zu analysieren und abhängig hiervon einen zweiten Lautheitswert (LW2) zu ermitteln und diesen mit Zuordnung zu der zweiten der zwei Audioquellen (AQ2) zu speichern;
einen Lautstärkenregler (14), der ausgebildet ist, um das Audiosignal der aktuell gewählten ersten der zwei Audioquellen (AQ1) entsprechend dem entsprechenden ersten Lautheitswert (LW1) anzupassen und um das Audiosignal der aktuell gewählten zweiten der zwei Audioquellen (AQ2) entsprechend dem entsprechenden zweiten Lautheitswert (LW2) anzupassen;
wobei die Vorrichtung so konfiguriert ist,
dass die Zeitdauer in einer Lernphase je Audioquelle (AQ1, AQ2) mindestens 30 Sekunden, bevorzugt mindestens 60 oder 150 Sekunden beträgt, dass der Lautheitsanalysator (12) die Lernphase dann durchführt, wenn für die jeweilige Audioquelle (AQ1, AQ2) noch kein Lautheitswert (LW1, LW2) gespeichert ist;
dass Zeitdauer in einer Adaptionsphase für die jeweilige Audioquellen (AQ1, AQ2) mindestens 5 Sekunden, oder bevorzugt mindestens 60 Sekunden oder 300 Sekunden beträgt, dass der Lautheitsanalysator (12) in der Adaptionsphase den ersten oder zweiten Lautheitswert (LW1, LW2) anpasst;
dass das Anpassen (130) des ersten Lautheitswert (LW1) durch den Lautstärkenregler (14) dadurch erfolgt, dass in der Adaptionsphase ein jeweils weiterer erster Lautheitswert (LW1) ermittelt wird, dass zur Anpassung des jeweils ersten Lautheitswerts (LW1) eine Verrechnung des jeweils weiteren ersten Lautheitswerts (LW1) mit dem jeweils ersten Lautheitswerts (LW1) erfolgt, dass das Anpassen (130) des zweiten Lautheitswert (LW1, LW2) durch den Lautstärkenregler (14) dadurch erfolgt, dass in der Adaptionsphase ein jeweils weiterer zweiter Lautheitswert (LW2) ermittelt wird, dass zur Anpassung des jeweils zweiten Lautheitswerts (LW2) eine Verrechnung des jeweils weiteren zweiten Lautheitswerts (LW2) mit dem jeweils zweiten Lautheitswerts (LW2) erfolgt;
dass bei der Verrechnung eine Gewichtung der jeweils ersten Lautheitswerte (LW1) und eine Gewichtung der jeweils weiteren ersten Lautheitswerte (LW1) erfolgt und dass bei der Verrechnung eine Gewichtung der jeweils zweiten Lautheitswerte (LW2) und eine Gewichtung der jeweils weiteren zweiten Lautheitswerte (LW2) erfolgt;
dass während des Betriebs der Audioquelle neue jeweils erste Lautheitswerte (LW1) nur dann ermittelt und gespeichert werden, wenn die jeweils weiteren ersten Lautheitswerte (LW1) um mindestens 10 % von den jeweils gespeicherten ersten Lautheitswerten (LW1) abweichen und dass während des Betriebs der Audioquelle neue jeweils zweite Lautheitswerte (LW2) durch den Lautheitsanalysator (12) nur dann ermittelt und gespeichert werden, wenn die jeweils weiteren zweiten Lautheitswerte (LW2) um mindestens 10 % von den jeweils gespeicherten zweiten Lautheitswerten (LW2) abweichen;
dass die Gewichtung so gewählt ist, dass die jeweils weiteren ersten Lautheitswerte (LW1) den jeweils neuen ersten Lautheitswert (LW1) weniger beeinflussen als die jeweils gespeicherten ersten Lautheitswerte (LW1); und dass die Gewichtung so gewählt ist, dass die jeweils weiteren zweiten Lautheitswerte (LW2) den jeweils neuen zweiten Lautheitswert (LW2) weniger beeinflussen als die jeweils gespeicherten zweiten Lautheitswerte (LW2).

2. Vorrichtung (10) gemäß Anspruch 1, wobei die zumindest zwei Audioquellen (AQ1, AQ2) unterschiedliche, aber gleichartige Audioquellen (AQ1, AQ2) sind oder wobei die zwei Audioquellen (AQ1, AQ2) zwei unterschiedliche Radiosender sind.

3. Vorrichtung (10) gemäß Anspruch 1 oder 2, wobei die Vorrichtung so konfiguriert ist, dass der erste Lautheitswert einen Mittelwert über die Zeitdauer der gemessenen Lautheit der ersten der zwei Audioquellen (AQ1, AQ2) darstellt und wobei der zweite Lautheitswert einen Mittelwert über die Zeitdauer der gemessenen Lautheit der zweiten der zwei Audioquellen (AQ1, AQ2) darstellt.

4. Vorrichtung (10) gemäß einem der vorherigen Ansprüche, wobei der Lautheitsanalysator (12) ausgebildet ist, um das Audiosignal der gewählten ersten der zwei Audioquellen (AQ1, AQ2) während der Lernphase zu analysieren und für das Audiosignal der aktuell gewählten ersten der zwei Audioquellen (AQ1, AQ2) einen vorläufigen Lautheitswert oder einen aktuellen, vorläufigen Lautheitswert zu bestimmen und um das Audiosignal der gewählten zweiten der zwei Audioquellen (AQ1, AQ2) während der Lernphase zu analysieren und für das Audiosignal der aktuell gewählten zweiten der zwei Audioquellen (AQ1, AQ2) einen vorläufigen Lautheitswert oder einen aktuellen, vorläufigen Lautheitswert zu bestimmen,
wobei der Lautstärkenregler (14) ausgebildet ist, um das Audiosignal der aktuell gewählten ersten der zwei Audioquellen (AQ1, AQ2) entsprechend dem vorläufigen Lautheitswert oder dem aktuellen, vorläufigen Lautheitswert anzupassen und um das Audiosignal der aktuell gewählten zweiten der zwei Audioquellen (AQ1, AQ2) entsprechend dem vorläufigen Lautheitswert oder dem aktuellen, vorläufigen Lautheitswert anzupassen.

5. Vorrichtung (10) gemäß einem der vorherigen Ansprüche, wobei die Vorrichtung so konfiguriert ist, dass der erste und zweite Lautheitswert (LW1, LW2) während des Betriebs unverändert bleibt.

6. Vorrichtung (10) gemäß einem der vorherigen Ansprüche, wobei die Vorrichtung so konfiguriert ist, dass der erste und der zweite Lautheitswert (LW1, LW2) so gewählt ist, dass die nach der Anpassung resultierende mittlere Lautheit oder mittlere Lautstärke des Audiosignals der ersten der zwei Audioquellen (AQ1, AQ2) der nach der Anpassung resultierende Lautheit oder Lautstärke des Audiosignals der zweiten der zwei Audioquellen (AQ1, AQ2) mit einer Abweichung von +/- 10 % gleicht.

7. Vorrichtung (10) gemäß einem der vorherigen Ansprüche, wobei der Lautheitsanalysator (12) ausgebildet ist, das Audiosignal der aktuell gewählten ersten und/oder zweiten der zwei Audioquellen (AQ1, AQ2) zu analysieren.

8. Radiotuner (40) mit einer Vorrichtung (10) gemäß einem der Ansprüche 1 bis 7.

9. Radiotuner (40) gemäß Anspruch 8, wobei der Radiotuner (40) als Doppel-Tuner ausgeführt ist.

10. Vorrichtung (10) gemäß einem der vorherigen Ansprüche, wobei der Lautheitsanalysator (12) ausgebildet ist, das Audiosignal der nicht aktuell gewählten ersten und/oder zweiten Audioquelle (AQ1, AQ2) zu analysieren.

11. Verfahren (100) zur Lautstärkenregulierung für zumindest zwei Audioquellen (AQ1, AQ2), mit folgenden Schritten:
Analysieren (110) eines Audiosignals der ersten der zwei Audioquellen (AQ1) über eine Zeitdauer und Ermitteln in Abhängigkeit hiervon eines ersten Lautheitswerts (LW1) und Speichern dieses ersten Lautheitswerts (LW1) mit Zuordnung zu der ersten Audioquelle (AQ1);
Analysieren (120) eines Audiosignals einer zweiten der zwei Audioquellen (AQ2) über eine Zeitdauer und Ermitteln abhängig hiervon eines zweiten Lautheitswerts (LW2) und Speichern dieses zweiten Lautheitswerts (LW2) mit Zuordnung zu der zweiten Audioquelle (AQ2); und
Anpassen (130) der Lautstärke des Audiosignals der ersten Audioquelle (AQ1) entsprechend dem jeweiligen ersten Lautheitswerts (LW1);
Anpassen (130) der Lautstärke des Audiosignals der zweiten Audioquelle (AQ2) entsprechend dem jeweiligen zweiten Lautheitswerts (LW2);
wobei die Zeitdauer in einer Lernphase je Audioquelle (AQ1, AQ2) mindestens 30 Sekunden, bevorzugt mindestens 60 oder 150 Sekunden beträgt, wobei der Lautheitsanalysator (12) die Lernphase dann durchführt, wenn für die jeweilige Audioquelle (AQ1, AQ2) noch kein Lautheitswert (LW1, LW2) gespeichert ist;
wobei die Zeitdauer in einer Adaptionsphase für die jeweilige Audioquellen (AQ1, AQ2) mindestens 5 Sekunden, oder bevorzugt mindestens 60 Sekunden oder 300 Sekunden beträgt, wobei der Lautheitsanalysator (12) in der Adaptionsphase den ersten oder zweiten Lautheitswert (LW1, LW2) anpasst;
wobei das Anpassen (130) des ersten Lautheitswerts (LW1) dadurch erfolgt, dass in der Adaptionsphase ein jeweils weiterer erster Lautheitswert (LW1) ermittelt wird, wobei zur Anpassung des jeweils ersten Lautheitswerts (LW1) eine Verrechnung des jeweils weiteren ersten Lautheitswerts (LW1) mit dem jeweils ersten Lautheitswerts (LW1) erfolgt, und wobei das Anpassen (130) des zweiten Lautheitswert (LW1, LW2) dadurch erfolgt, dass in der Adaptionsphase ein jeweils weiterer zweiter Lautheitswert (LW2) ermittelt wird, wobei zur Anpassung des jeweils zweiten Lautheitswerts (LW2) eine Verrechnung des jeweils weiteren zweiten Lautheitswerts (LW2) mit dem jeweils zweiten Lautheitswerts (LW2) erfolgt;
wobei bei der Verrechnung eine Gewichtung der jeweils ersten Lautheitswerte (LW1) und eine Gewichtung der jeweils weiteren ersten Lautheitswerte (LW1) erfolgt und wobei bei der Verrechnung eine Gewichtung der jeweils zweiten Lautheitswerte (LW2) und eine Gewichtung der jeweils weiteren zweiten Lautheitswerte (LW2) erfolgt;
wobei während des Betriebs der Audioquelle neue jeweils erste Lautheitswerte (LW1) nur dann ermittelt und gespeichert werden, wenn die jeweils weiteren ersten Lautheitswerte (LW1) um mindestens 10 % von den jeweils gespeicherten ersten Lautheitswerten (LW1) abweichen und wobei während des Betriebs der Audioquelle weitere neue jeweils zweite Lautheitswerte (LW2) nur dann ermittelt und gespeichert werden, wenn die jeweils weiteren zweiten Lautheitswerte (LW2) um mindestens 10 %
von den jeweils gespeicherten zweiten Lautheitswerten (LW2) abweichen;
wobei die Gewichtung so gewählt ist, dass die jeweils weiteren ersten Lautheitswerte (LW1) den jeweils neuen ersten Lautheitswert (LW1) weniger beeinflussen als die jeweils gespeicherten ersten Lautheitswerte (LW1); und wobei die Gewichtung so gewählt ist, dass die jeweils weiteren zweiten Lautheitswerte (LW2) den jeweils neuen zweiten Lautheitswert (LW2) weniger beeinflussen als die jeweils gespeicherten zweiten Lautheitswerte (LW2).

12. Computerprogramm umfassend Befehle, die bei der Ausführung des Programms durch einen Computer diesen veranlassen, das Verfahren nach Anspruch 11 auszuführen.

## Claims

1. A device (10) for volume control for at least two audio sources (AQ1, AQ2), the device comprising:
a loudness analyzer (12) configured to analyze an audio signal of the first one of the two audio sources (AQ1) over a time period and to determine a first loudness value (LW1) as a function thereof, and to store said loudness value while associating it with the first one of the two audio sources (AQ1), and to analyze an audio signal of the second one of the two audio sources (AQ2) over a time period, and to determine a second loudness value (LW2) as a function thereof, and to store said loudness value while associating it with the second one of the two audio sources (AQ2);
a volume regulator (14) configured to adapt the audio signal of the currently selected first one of the two audio sources (AQ1) in accordance with the corresponding first loudness value (LW1) and to adapt the audio signal of the currently selected second one of the two audio sources (AQ2) in accordance with the corresponding second loudness value (LW2);
wherein the device is configured such that:
the time period in a learning phase amounts to at least 30 seconds, preferably at least 60 or 150 seconds, for each audio source (AQ1, AQ2), such that the loudness analyzer (12) performs the learning phase when no loudness value (LW1, LW2) has yet been stored for the respective audio source (AQ1, AQ2);
the time period during an adaptation phase amounts to at least 5 seconds, or preferably at least 60 seconds or 300 seconds for the respective audio sources (AQ1, AQ2), such that the loudness analyzer (12) adapts the first or second loudness value (LW1, LW2) during the adaptation phase;
said adaptation (130) of the first loudness value (LW1) by the volume regulator (14) is performed by determining a respectively further first loudness value (LW1) during the adaptation phase,
wherein for the adaptation of the respectively first loudness value (LW1) the respectively further first loudness value (LW1) is offset against the respectively first loudness value (LW1),
said adaptation (130) of the second loudness value (LW2) by the volume regulator (14) is performed by determining a respectively further second loudness value (LW2) during the adaptation phase,
wherein for the adaptation of the respectively second loudness value (LW2) the respectively further second loudness value (LW2) is offset against the respectively second loudness value (LW2);
said offsetting involves weighting of the respectively first loudness values (LW1) and weighting of the respectively further first loudness values (LW1), and said offsetting involves weighting of the respectively second loudness values (LW2) and weighting of the respectively further second loudness values (LW2);
during operation of the audio source, new further respectively first loudness values (LW1) are determined and stored only if the respectively further first loudness values (LW1) deviate by at least 10% from the respectively stored first loudness values (LW1), and
during operation of the audio source, new further respectively second loudness values (LW2) are determined and stored by the loudness analyzer (12) only if the respectively further second loudness values (LW2) deviate by at least 10% from the respectively stored second loudness values (LW2);
said weighting is selected such that the respectively further first loudness values (LW1) exert less influence on the respectively new first loudness value (LW1) than the respectively stored first loudness values (LW1); and said weighting is selected such that the respectively further second loudness values (LW2) exert less influence on the respectively new second loudness value (LW2) than the respectively stored second loudness values (LW2).

2. The device (10) as claimed in claim 1, wherein the at least two audio sources (AQ1, AQ2) are different, but similar audio sources (AQ1, AQ2), or wherein the two audio sources (AQ1, AQ2) are two different radio stations.

3. The device (10) as claimed in claim 1 or 2, wherein the device is configured such that the first loudness value represents an average value over the time period of the measured loudness of the first one of the two audio sources (AQ1, AQ2), and wherein the second loudness value represents an average value over the time period of the measured loudness of the second one of the two audio sources (AQ1, AQ2).

4. The device (10) as claimed in any of the previous claims, wherein the loudness analyzer (12) is configured to analyze the audio signal of the selected first one of the two audio sources (AQ1, AQ2) during the learning phase and to determine a preliminary loudness value or a current, preliminary loudness value for the audio signal of the currently selected first one of the two audio sources (AQ1, AQ2), and to analyze the audio signal of the selected second one of the two audio sources (AQ1, AQ2) during the learning phase and to determine a preliminary loudness value or a current, preliminary loudness value for the audio signal of the currently selected second one of the two audio sources (AQ1, AQ2),
wherein the volume regulator (14) is configured to adapt the audio signal of the currently selected first one of the two audio sources (AQ1, AQ2) in accordance with the preliminary loudness value or the current, preliminary loudness value, and to adapt the audio signal of the currently selected second one of the two audio sources (AQ1, AQ2) in accordance with the preliminary loudness value or the current, preliminary loudness value.

5. The device (10) as claimed in any of the previous claims, wherein the device is configured such that the first and the second loudness value (LW1, LW2) remain unchanged during operation.

6. The device (10) as claimed in any of the previous claims, wherein the device is configured such that the first and the second loudness value (LW1, LW2) is selected such that the average loudness or average volume, which results after the adaptation, of the audio signal of the first one of the two audio sources (AQ1, AQ2) equals the loudness or volume, which results after the adaptation, of the audio signal of the second one of the two audio sources (AQ1, AQ2) with a deviation of +/- 10%.

7. The device (10) as claimed in any of the previous claims, wherein the loudness analyzer (12) is configured to analyze the audio signal of the currently selected first and/or second one of the two audio sources (AQ1, AQ2).

8. A radio tuner (40) comprising a device (10) as claimed in any of claims 1 to 7.

9. The radio tuner (40) as claimed in claim 8, the radio tuner (40) being configured as a double tuner.

10. The device (10) as claimed in any of the previous claims, wherein the loudness analyzer (12) is configured to analyze the audio signal of the not currently selected first and/or second audio source (AQ1, AQ2).

11. A method (100) of volume control for at least two audio sources (AQ1, AQ2), comprising:
analyzing (110) an audio signal of the first one of the two audio sources (AQ1) over a time period, and determining a first loudness value (LW1) as a function thereof, and storing said first loudness value (LW1) while associating it with the first audio source (AQ1);
analyzing (120) an audio signal of a second one of the two audio sources (AQ2) over a time period, and determining a second loudness value (LW2) as a function thereof, and storing said second loudness value (LW2) while associating it with the second audio source (AQ2); and
adapting (130) the volume of the audio signal of the first audio source (AQ1) in accordance with the respective first loudness value (LW1);
adapting (130) the volume of the audio signal of the second audio source (AQ2) in accordance with the respective second loudness value (LW2);
wherein the time period in a learning phase amounts to at least 30 seconds, preferably at least 60 or 150 seconds, for each audio source (AQ1, AQ2), wherein the loudness analyzer (12) performs the learning phase when no loudness value (LW1, LW2) has yet been stored for the respective audio source (AQ1, AQ2);
wherein the time period during an adaptation phase amounts to at least 5 seconds, or preferably at least 60 seconds or 300 seconds for the respective audio sources (AQ1, AQ2), wherein the loudness analyzer (12) adapts the first or second loudness value (LW1, LW2) during the adaptation phase;
wherein said adapting (130) of the first loudness value (LW1) is performed by determining a respectively further first loudness value (LW1) during the adaptation phase,
wherein for the adaptation of the respectively first loudness value (LW1) the respectively further first loudness value (LW1) is offset against the respectively first loudness value (LW1), and wherein said adapting (130) of the second loudness value (LW1, LW2) is performed by determining a respectively further second loudness value (LW2) during the adaptation phase, wherein for the adaptation of the respectively second loudness value (LW2) the respectively further second loudness value (LW2) is offset against the respectively second loudness value (LW2);
wherein said offsetting involves weighting of the respectively first loudness values (LW1) and weighting of the respectively further first loudness values (LW1), and wherein said offsetting involves weighting of the respectively second loudness values (LW2) and weighting of the respectively further second loudness values (LW2);
wherein during operation of the audio source, new further respectively first loudness values (LW1) are determined and stored only if the respectively further first loudness values (LW1) deviate by at least 10% from the respectively stored first loudness values (LW1), and wherein during operation of the audio source, further new respectively second loudness values (LW2) are determined and stored only if the respectively further second loudness values (LW2) deviate by at least 10% from the respectively stored second loudness values (LW2);
wherein said weighting is selected such that the respectively further first loudness values (LW1) exert less influence on the respectively new first loudness value (LW1) than the respectively stored first loudness values (LW1); and wherein said weighting is selected such that the respectively further second loudness values (LW2) exert less influence on the respectively new second loudness value (LW2) than the respectively stored second loudness values (LW2).

12. A computer program having instructions that, when the program is executed by a computer, cause said computer to perform the method according to claim 11.

## Revendications

1. Dispositif (10) de régulation de l'intensité sonore pour au moins deux sources audio (AQ1, AQ2), le dispositif contenant:
un analyseur de volume sonore (12) qui est conçu pour analyser un signal audio de la première des deux sources audio (AQ1) sur une période de temps et pour déterminer, en fonction de cette analyse, une première valeur de volume sonore (LW1) et pour la mémoriser avec association à la première des deux sources audio (AQ1) et pour analyser un signal audio de la deuxième des deux sources audio (AQ2) sur une période de temps et pour déterminer, en fonction de cette analyse, une deuxième valeur de volume sonore (LW2) et pour la mémoriser avec association à la deuxième des deux sources audio (AQ2);
un régulateur d'intensité sonore (14) qui est conçu pour adapter le signal audio de la première source actuellement sélectionnée parmi les deux sources audio (AQ1) en fonction de la première valeur de volume sonore correspondante (LW1) et pour adapter le signal audio de la deuxième source actuellement sélectionnée parmi les deux sources audio (AQ2) en fonction de la valeur de volume sonore correspondante (LW2);
dans lequel le dispositif est configuré de sorte
que la durée d'une phase d'apprentissage par source audio (AQ1, AQ2) soit d'au moins 30 secondes, de préférence d'au moins 60 ou 150 secondes, que l'analyseur de volume sonore (12) effectue la phase d'apprentissage lorsqu'il n'a pas encore été enregistré de valeur de volume sonore (LW1, LW2) pour la source audio respective (AQ1, AQ2);
que la durée d'une phase d'adaptation pour les sources audio respectives (AQ1, AQ2) soit d'au moins 5 secondes, ou de préférence d'au moins 60 secondes ou 300 secondes, que l'analyseur de volume sonore (12) adapte la première ou la deuxième valeur de volume sonore (LW1, LW2) dans la phase d'adaptation;
que l'adaptation (130) de la première valeur de volume sonore (LW1) par le régulateur de volume sonore (14) ait lieu par le fait que dans la phase d'adaptation est déterminée une autre première valeur de volume sonore respective (LW1),
que pour adapter la première valeur de volume sonore respective (LW1) ait lieu une compensation de l'autre première valeur de volume sonore respective (LW1) avec la première valeur de volume sonore respective (LW1),
que l'adaptation (130) de la deuxième valeur de volume sonore (LW1, LW2) par le régulateur de volume (14) ait lieu du fait qu'il est déterminé, dans la phase d'adaptation, une autre deuxième valeur de volume sonore respective (LW2),
que pour l'adaptation de la deuxième valeur de volume sonore respective (LW2) ait lieu une compensation de l'autre deuxième valeur de volume sonore respective (LW2) avec la deuxième valeur de volume sonore respective (LW2);
que lors de la compensation ait lieu une pondération des premières valeurs de volume sonore respectives (LW1) et une pondération des autres premières valeurs de volume sonore respectives (LW1), et qu'ait lieu une pondération des deuxièmes valeurs de volume sonore respectives (LW2) et une pondération des autres deuxièmes valeurs de volume sonore respectives (LW2);
que pendant le fonctionnement de la source audio de nouvelles premières valeurs de volume sonore respectives (LW1) ne soient déterminées et mémorisées que lorsque les autres premières valeurs de volume sonore respectives (LW1) s'écartent d'au moins 10% des premières valeurs de volume sonore respectives mémorisées (LW1), et
que pendant le fonctionnement de la source audio de nouvelles deuxièmes valeurs de volume sonore respectives (LW2) ne soient déterminées et mémorisées par l'analyseur de volume sonore (12) que lorsque les autres deuxièmes valeurs de volume sonore respectives (LW2) s'écartent d'au moins 10% des deuxièmes valeurs de volume sonore respectives mémorisées (LW2);
que la pondération soit sélectionnée de sorte que les autres premières valeurs de volume sonore respectives (LW1) influencent moins la nouvelle première valeur de volume sonore respective (LW1) que les premières valeurs de volume sonore respectives mémorisées (LW1); et
que la pondération soit sélectionnée de sorte que les autres deuxièmes valeurs de volume sonore respectives (LW2) influencent moins la nouvelle deuxième valeur de volume sonore respective (LW2) que les deuxièmes valeurs de volume sonore respectives mémorisées (LW2).

2. Dispositif (10) selon la revendication 1, dans lequel les au moins deux sources audio (AQ1, AQ2) sont des sources audio différentes, mais similaires (AQ1, AQ2), ou dans lequel les deux sources audio (AQ1, AQ2) sont deux stations de radio différentes.

3. Dispositif (10) selon la revendication 1 ou 2, dans lequel le dispositif est configuré de sorte que la première valeur de volume sonore représente une valeur moyenne sur la durée du volume sonore mesuré de la première des deux sources audio (AQ1, AQ2) et dans lequel la deuxième valeur de volume sonore représente une valeur moyenne sur la durée du volume sonore mesuré de la deuxième des deux sources audio (AQ1, AQ2).

4. Dispositif (10) selon l'une des revendications précédentes, dans lequel l'analyseur de volume sonore (12) est conçu pour analyser le signal audio de la première source sélectionnée parmi les deux sources audio (AQ1, AQ2) pendant la phase d'apprentissage et pour déterminer, pour le signal audio de la première source actuellement sélectionnée parmi les deux sources audio (AQ1, AQ2), une valeur de volume sonore provisoire ou une valeur de volume sonore provisoire actuelle et pour analyser le signal audio de la deuxième source sélectionnée parmi les deux sources audio (AQ1, AQ2) pendant la phase d'apprentissage et pour déterminer, pour le signal audio de la deuxième source actuellement sélectionnée parmi les deux sources audio (AQ1, AQ2), une valeur de volume sonore provisoire ou une valeur de volume sonore provisoire actuelle,
dans lequel le régulateur de volume sonore (14) est conçu pour adapter le signal audio de la première source actuellement sélectionnée parmi les deux sources audio (AQ1, AQ2) en fonction de la valeur de volume sonore provisoire ou de la valeur de volume sonore provisoire actuelle et pour adapter le signal audio de la deuxième source actuellement sélectionnée parmi les deux sources audio (AQ1, AQ2) en fonction de la valeur de volume sonore provisoire ou la valeur de volume sonore provisoire actuelle.

5. Dispositif (10) selon l'une des revendications précédentes, dans lequel le dispositif est configuré de sorte que les première et deuxième valeurs de volume sonore (LW1, LW2) restent inchangées pendant le fonctionnement.

6. Dispositif (10) selon l'une des revendications précédentes, dans lequel le dispositif est configuré de sorte que la première et la deuxième valeur de volume sonore (LW1, LW2) soient sélectionnées de sorte que le volume sonore moyen ou l'intensité sonore moyenne du signal audio résultant après l'adaptation de la première des deux sources audio (AQ1, AQ2) soit égal au volume sonore ou à l'intensité sonore du signal audio résultant après l'adaptation de la deuxième des deux sources audio (AQ1, AQ2) avec un écart de +/- 10%.

7. Dispositif (10) selon l'une des revendications précédentes, dans lequel l'analyseur de volume sonore (12) est conçu pour analyser le signal audio de la première et/ou de la deuxième source actuellement sélectionnée parmi les deux sources audio (AQ1, AQ2).

8. Syntoniseur de radio (40) avec un dispositif (10) selon l'une des revendications 1 à 7.

9. Syntoniseur de radio (40) selon la revendication 8, dans lequel le syntoniseur de radio (40) est conçu comme un syntoniseur double.

10. Dispositif (10) selon l'une des revendications précédentes, dans lequel l'analyseur de volume sonore (12) est conçu pour analyser le signal audio de la première et/ou deuxième source audio non sélectionnée actuellement (AQ1, AQ2).

11. Procédé (100) permettant de réguler l'intensité sonore pour au moins deux sources audio (AQ1, AQ2), aux étapes suivantes consistant à:
analyser (110) un signal audio de la première des deux sources audio (AQ1) sur une période de temps et déterminer, en fonction de cette analyse, une première valeur de volume sonore (LW1) et mémoriser cette première valeur de volume sonore (LW1) avec association à la première source audio (AQ1);
analyser (120) un signal audio d'une deuxième des deux sources audio (AQ2) sur une période de temps et déterminer, en fonction de cette analyse, une deuxième valeur de volume sonore (LW2) et mémoriser cette deuxième valeur de volume sonore (LW2) avec association à la deuxième source audio (AQ2); et
adapter (130) l'intensité sonore du signal audio de la première source audio (AQ1) selon la première valeur de volume sonore respective (LW1);
adapter (130) l'intensité sonore du signal audio de la deuxième source audio (AQ2) selon la deuxième valeur de volume sonore respective (LW2);
dans lequel la durée d'une phase d'apprentissage par source audio (AQ1, AQ2) est d'au moins 30 secondes, de préférence d'au moins 60 ou 150 secondes, dans lequel l'analyseur de volume sonore (12) effectue la phase d'apprentissage lorsqu'il n'a pas encore été enregistré de valeur de volume sonore (LW1, LW2) pour la source audio respective (AQ1, AQ2);
dans lequel la durée d'une phase d'adaptation pour les sources audio respectives (AQ1, AQ2) est d'au moins 5 secondes, ou de préférence d'au moins 60 secondes ou 300 secondes, dans lequel l'analyseur de volume sonore (12) adapte la première ou la deuxième valeur de volume sonore (LW1, LW2) dans la phase d'adaptation;
dans lequel l'adaptation (130) de la première valeur de volume sonore (LW1) a lieu par le fait que dans la phase d'adaptation est déterminée une autre première valeur de volume sonore respective (LW1), où pour l'adaptation de la première valeur de volume sonore respective (LW1) a lieu une compensation de l'autre première valeur de volume sonore respective (LW1) avec la première valeur de volume sonore respective (LW1), et dans lequel l'adaptation (130) de la deuxième valeur de volume sonore (LW1, LW2) a lieu par le fait que dans la phase d'adaptation est déterminée une autre deuxième valeur de volume sonore respective (LW2), où pour l'adaptation de la deuxième valeur de volume sonore respective (LW2) a lieu une compensation de l'autre deuxième valeur de volume sonore respective (LW2) avec la deuxième valeur de volume sonore respective (LW2);
dans lequel a lieu, pendant la compensation, une pondération des premières valeurs de volume sonore respectives (LW1) et une pondération des autres premières valeurs de volume sonore respectives (LW1), et dans lequel a lieu, pendant la compensation, une pondération des deuxièmes valeurs de volume sonore respectives (LW2) et une pondération des autres deuxièmes valeurs de volume sonore respectives (LW2);
dans lequel, pendant le fonctionnement de la source audio, de nouvelles premières valeurs de volume sonore respectives (LW1) ne sont déterminées et mémorisées que lorsque les autres premières valeurs de volume sonore respectives (LW1) s'écartent d'au moins 10% des premières valeurs de volume sonore respectives mémorisées (LW1) et dans lequel, pendant le fonctionnement de la source audio, d'autres nouvelles deuxièmes valeurs de volume sonore respectives (LW2) ne sont déterminées et mémorisées que lorsque les autres deuxièmes valeurs de volume sonore respectives (LW2) s'écartent d'au moins 10% des deuxièmes valeurs de volume sonore respectivement mémorisées (LW2);
dans lequel la pondération est sélectionnée de sorte que les autres premières valeurs de volume sonore respectives (LW1) influencent la nouvelle première valeur de volume sonore respective (LW1) moins que les premières valeurs de volume sonore respectives mémorisées (LW1); et dans lequel la pondération est sélectionnée de sorte que les autres deuxièmes valeurs de volume sonore respectives (LW2) influencent la nouvelle deuxième valeur de volume sonore respective (LW2) moins que les deuxièmes valeurs de volume sonore respectives mémorisées (LW2).

12. Programme d'ordinateur comportant des instructions qui, lors de l'exécution du programme par un ordinateur, amènent ce dernier à réaliser le procédé selon la revendication 11.
